# FASCICULE DE BREVET EUROPEEN

(11) **EP 3 512 057 B1**
(45) Date de publication et mention de la délivrance du brevet: **30.11.2022**
(21) Numéro de dépôt: 19151440.5
(22) Date de dépôt: 11.01.2019
(51) Int. Cl.: H02B 1/30, H01H 9/16, H01P 1/04, H01P 5/02, H02J 13/00, H01Q 1/48, H01Q 9/30, H04B 7/155, H02B 1/052, H01H 71/04

(54) **APPAREIL ÉLECTRIQUE COMMUNIQUANT SANS FIL ET ARMOIRE ÉLECTRIQUE COMPRENANT CET APPAREIL ÉLECTRIQUE**
ELEKTRISCHES GERÄT, DAS DRAHTLOS KOMMUNIZIERT, UND ELEKTRISCHER SCHALTSCHRANK, DER EIN SOLCHES ELEKTRISCHES GERÄT UMFASST
WIRELESS COMMUNICATION ELECTRICAL APPARATUS AND ELECTRICAL CABINET COMPRISING SAID ELECTRICAL APPARATUS

(30) Priorité: 11.01.2018 FR 1850240
(43) Date de publication de la demande: 17.07.2019
(73) Titulaire: Schneider Electric Industries SAS, 92500 Rueil Malmaison (FR)
(72) Inventeur: NIEMBRO, Alejandro, 380580 Grenoble Cedex 09 (FR); DREINA, Emmanuel, 38050 Grenoble Cedex 09 (FR)
(74) Mandataire: Lavoix

(56) Documents cités:
- EP-A1- 2 927 928
- WO-A1-2014/044736
- WO-A1-2015/068359
- WO-A1-2016/128668
- FR-A1- 2 686 465
- US-A1- 2013 002 376
- US-B1- 6 545 572

## Description

L'invention concerne un appareil électrique communiquant sans fil. L'invention concerne également une armoire électrique comprenant un tel appareil électrique.

L'invention s'applique notamment aux appareils de gestion d'un courant électrique, par exemple des appareils de protection et de commutation électrique ou de mesure, tels que des disjoncteurs ou des contacteurs, ou des appareils de mesure d'un courant électrique.

De nos jours, de tels appareils électriques sont couramment équipés d'un calculateur électronique embarqué et de moyens de communication sans fil. Cela permet de commander et de superviser à distance le fonctionnement de ces appareils.

Typiquement, la communication entre l'appareil électrique et l'extérieur est réalisée par une liaison radio à longue portée, par exemple selon un protocole LoRa, SigFox, ou encore LTE ou Wifi. Pour ce faire, l'appareil électrique inclut une antenne radio, qui est disposée à l'intérieur de l'appareil.

WO 2016/128668 A1 décrit un exemple d'un appareil électrique comportant une antenne selon le préambule de la revendication 1.

Un problème se pose lorsque l'appareil est installé dans une armoire électrique dont les parois sont métalliques, comme cela est souvent le cas dans des installations de distribution d'électricité industrielles ou domestiques. Les parois métalliques entravent la propagation des ondes radio, de sorte que la communication entre l'appareil et l'extérieur est dégradée, voire devient impossible.

Pour y remédier, il est connu d'utiliser une antenne radio supplémentaire, installée à l'extérieur de l'armoire électrique et raccordée à l'appareil par une liaison filaire, telle qu'un câble coaxial. Cela impose que l'appareil électrique soit pourvu d'un connecteur, tel qu'un connecteur SMA, pour permettre la connexion dudit câble.

Toutefois, cette solution n'est pas entièrement satisfaisante, car il existe alors un risque d'électrocution pour des utilisateurs. En effet, les installations électriques sur lesquelles l'appareil électrique est raccordé présentent généralement des tensions électriques élevées, par exemple supérieures ou égales à 110 volts ou à 230 volts, voire plus. Les moyens de communication radio sont typiquement alimentés électriquement à partir de ces tensions électriques. En cas de défaut d'isolation électrique au sein de l'appareil, le connecteur risque d'être accidentellement exposé à ces tensions électriques, ce n'est pas acceptable.

Pour y remédier, il est possible d'équiper l'appareil d'un système d'isolation galvanique. Toutefois, cette solution impose un certain nombre de contraintes techniques et industrielles, notamment en termes de coût, d'encombrement et de complexité de fabrication de l'appareil électrique.

De plus, lorsque l'appareil électrique est fabriqué, il n'est pas possible de savoir quelle sera l'utilisation qui en sera faite par les utilisateurs. Si un utilisateur décide de placer l'appareil dans une armoire électrique qui n'est pas pourvue de paroi métallique, alors aucune antenne extérieure ne sera nécessaire et l'isolation galvanique sera alors superflue. Il faudrait donc prévoir plusieurs versions de chaque appareil électrique, selon qu'il sera destiné à être utilisé ou non avec une antenne extérieure. Une telle solution n'est pas applicable en pratique, car cela conduirait à démultiplier le nombre de produits pour chaque gamme de produits, ce qui poserait des problèmes d'industrialisation.

Il existe donc un besoin pour un appareil électrique de gestion électrique destiné à être installé dans une armoire électrique et permettant une communication sans fil de sorte à remédier aux inconvénients précités.

A cet effet, l'invention concerne un appareil électrique destiné à être installé dans une armoire électrique, cet appareil électrique comportant
- un dispositif de gestion d'un courant électrique ;
- une unité de commande électronique comportant une interface de communication radio pourvue d'une antenne radio interne logée à l'intérieur d'un premier boîtier de l'appareil électrique ;

l'appareil électrique étant caractérisé en ce que l'antenne radio interne est une antenne planaire comportant un premier élément rayonnant,
en ce que l'appareil électrique comporte en outre un élément de couplage amovible connecté à une antenne radio extérieure, l'élément de couplage étant pourvu d'un deuxième élément rayonnant raccordé à l'antenne radio extérieure et étant déplaçable entre une position connectée avec le boîtier de l'appareil électrique et une position déconnectée du boîtier,

en ce que, dans la position connectée, l'élément de couplage est disposé en face de l'antenne radio interne en étant séparé de celle-ci par un élément électriquement isolant, le deuxième élément rayonnant étant couplé avec le premier élément rayonnant de sorte à recevoir un rayonnement électromagnétique émis par le premier élément rayonnant ;
et en ce que l'antenne radio interne comporte un substrat diélectrique et un plan de masse, le premier élément rayonnant et le plan de masse étant formés sur des faces opposées du substrat diélectrique et l'élément de couplage comporte un deuxième substrat diélectrique et un deuxième plan de masse, le deuxième élément rayonnant et le deuxième plan de masse étant formés sur des faces opposées du deuxième substrat diélectrique.

Grâce à l'invention, l'élément de couplage assure une connexion sans fil entre l'interface de communication radio et l'antenne extérieure, sans qu'il ne soit nécessaire d'utiliser un connecteur électrique filaire. On dispose ainsi d'un moyen simple de connecter une antenne externe sur l'appareil électrique, tout en limitant le risque d'électrocution d'un utilisateur, ceci sans qu'il ne soit nécessaire d'équiper l'appareil d'une isolation galvanique.

Selon des aspects avantageux mais non obligatoires de l'invention, un tel appareil électrique peut incorporer une ou plusieurs des caractéristiques suivantes, prises isolément ou suivant toute combinaison techniquement admissible :
- Le plan de masse de l'élément de couplage comporte une couche métallique qui présente une forme en C.
- Le boîtier de l'appareil comporte un logement interne destiné à recevoir l'élément de couplage lorsqu'il est dans la position connectée et un volume intérieur à l'intérieur duquel l'antenne interne est logée, le logement interne étant disposé en regard de l'antenne interne et en étant séparé de l'antenne interne par une paroi dudit boîtier.
- L'élément de couplage comporte un boîtier de protection indépendant du boîtier de l'appareil, le boîtier de protection comportant au moins un élément de détrompage destiné à coopérer avec un élément de guidage de forme complémentaire ménagé à l'intérieur du logement.
- L'élément de couplage est logé dans un deuxième boîtier distinct du boîtier de l'appareil, le deuxième boîtier présentant une forme analogue ou identique à celle du boîtier de l'appareil et en ce que dans la position connectée, ledit deuxième boîtier est disposé à l'extérieur du boîtier de l'appareil.
- L'élément isolant est au moins en partie formé par une paroi du boîtier de l'appareil.
- L'antenne interne est une antenne monopolaire, telle qu'une antenne quart d'onde.
- L'unité de commande comporte un circuit imprimé et en ce que l'antenne interne est formée sur ce circuit imprimé.
- Dans la position connectée, le module de couplage collecte au moins 60% de l'énergie rayonnée par l'antenne.

Selon un autre aspect, l'invention concerne une armoire électrique comportant un appareil électrique placé à l'intérieur de l'armoire électrique et raccordé à une installation électrique, cet appareil électrique étant tel que décrit précédemment, une antenne extérieure connectée à l'appareil électrique étant placée à l'extérieur de l'armoire électrique.

L'invention sera mieux comprise et d'autres avantages de celle-ci apparaîtront plus clairement à la lumière de la description qui va suivre, d'un mode de réalisation d'un appareil électrique, donnée uniquement à titre d'exemple et faite en référence aux dessins annexés, dans lesquels :
- la figure 1 est une représentation schématique d'un appareil électrique selon l'invention ;
- la figure 2 est une représentation schématique d'un exemple d'une antenne interne de l'appareil électrique de la figure 1, représentée selon une vue en perspective ;
- la figure 3 est une représentation schématique d'un exemple d'un élément de couplage du système de la figure 1, représenté selon une vue en perspective ;
- la figure 4 est une représentation schématique du système de la figure 1 selon une vue partiellement éclatée et selon un premier mode de réalisation de l'invention ;
- la figure 5 est une représentation schématique du système de la figure 4 selon une vue en coupe transversale ;
- la figure 6 est une représentation schématique d'un exemple du système de la figure 1 selon un deuxième mode de réalisation de l'invention ;
- la figure 7 est une représentation schématique du système de la figure 6 selon une vue en coupe transversale ;
- la figure 8 est un graphique représentant l'amplitude des paramètres de transmission et de réflexion du système formé par l'association de l'antenne de la figure 2 avec l'élément de couplage de la figure 3, en fonction de la fréquence du signal radio.

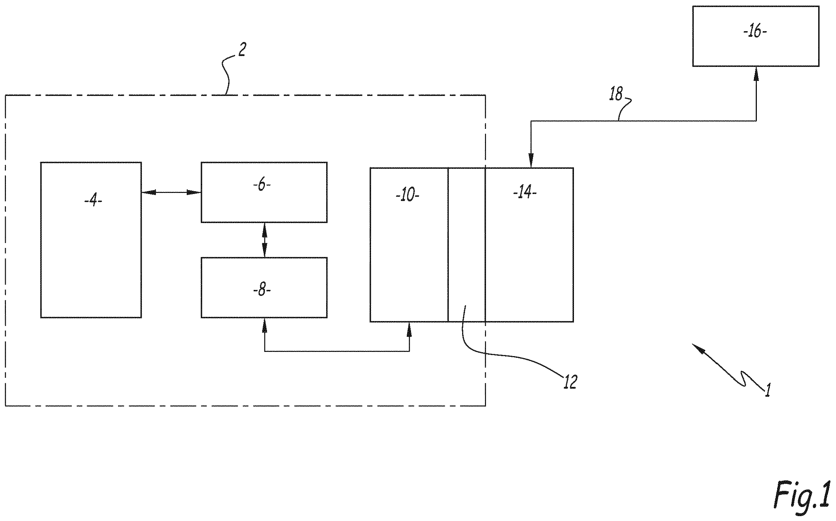

La figure 1 représente une armoire électrique 1 contenant un appareil électrique 2. Par exemple, l'armoire 1 comporte des parois, non illustrées, qui délimitent un logement à l'intérieur duquel l'appareil 2 est installé.

L'armoire électrique 1 définie ci-dessus désigne tous types de contenants pour appareils électriques notamment des armoires, des coffrets, des boîtes de raccordement, des goulottes ou des chemins de câbles.

L'appareil électrique 2 est ici un appareil de gestion d'un courant électrique destiné à être raccordé à une installation électrique, par exemple pour la protéger ou en superviser le fonctionnement.

A titre d'exemple, l'appareil électrique 2 est un appareil de protection électrique, tel qu'un disjoncteur. En variante, il peut s'agir d'un appareil de commutation ou de coupure du courant électrique, tel qu'un contacteur, un interrupteur ou un relais commandable, ou tout appareil équivalent. Selon d'autres exemples, il peut s'agir d'un appareil de mesure, tel qu'un compteur électrique ou un déclencheur. D'autres applications sont possibles.

L'appareil électrique 2 comporte un dispositif de gestion du courant électrique 4, une unité de commande électronique 6, une interface de communication radio 8 connectée avec l'unité 6 et une antenne radio interne 10.

L'appareil électrique 2 comporte en outre un premier boîtier, dit boîtier principal, par exemple un boîtier moulé en matière plastique, à l'intérieur duquel sont logés les constituants précités de l'appareil 2.

Dans cet exemple, l'appareil 2 est adapté pour être fixé sur un rail de fixation à l'intérieur de l'armoire 1, tel qu'un rail de fixation DIN, grâce à des organes de fixation appropriés, ici ménagés à l'arrière du premier boîtier.

Le dispositif 4 permet ici de gérer un courant électrique circulant au sein d'une installation électrique à laquelle est associé l'appareil 2. Par exemple, le dispositif 4 est apte à interrompre la circulation de ce courant de façon contrôlée et/ou apte à mesurer des caractéristiques physiques relatives à ce courant électrique (intensité, puissance, tension, phase...). En pratique, le dispositif 4 est raccordé électriquement à l'installation électrique, par exemple au moyen de plages de raccordement.

Par exemple, si l'appareil 2 est un appareil de protection électrique ou un appareil de commutation électrique, alors le dispositif 4 est un dispositif de coupure d'un courant électrique, par exemple à contacts séparables.

L'unité de commande 6 est configurée pour superviser le fonctionnement du dispositif 4 et/ou pour piloter le dispositif 4. Par exemple, l'unité 6 est apte à commander l'interruption d'un courant électrique par le dispositif 4, notamment en réponse à un ordre de commutation reçu depuis un émetteur extérieur par l'intermédiaire de l'interface 8. Selon des modes de réalisation, l'unité 6 peut aussi acquérir des valeurs de grandeurs électriques mesurées par le dispositif 4, en vue de les transmettre vers un récepteur distant extérieur à l'appareil 2, avec l'aide de l'interface 8.

A titre d'exemple, l'unité 6 comporte ici une unité logique de calcul, telle qu'un microcontrôleur programmable ou un microprocesseur. L'unité 6 contient également une ou plusieurs mémoires informatiques à l'intérieur desquelles sont enregistrées des instructions exécutables permettant d'assurer le fonctionnement de l'appareil 2.

L'interface de communication radio 8 est connectée avec l'antenne 10 pour envoyer et/ou recevoir des données par l'intermédiaire d'une liaison sans fil, notamment une liaison radio. Ainsi, l'interface 8 permet à l'appareil 2 de recevoir des instructions fournies par un émetteur distant et/ou d'émettre des informations vers un récepteur distant. L'antenne radio 10 est logée à l'intérieur du boîtier principal de l'appareil 2. En d'autres termes, elle n'est pas accessible physiquement depuis l'extérieur du boîtier principal de l'appareil 2. L'antenne 10 peut faire partie de l'interface 8.

L'antenne 10 est ici une antenne planaire comprenant au moins un élément rayonnant, de préférence en forme de ruban et réalisé en un matériau électriquement conducteur. Cet élément rayonnant est adapté pour émettre un rayonnement électromagnétique lorsqu'il est alimenté électriquement, par exemple lorsque l'interface 8 utilise l'antenne 10 pour émettre un signal radio. Cet élément rayonnant est décrit plus en détail dans ce qui suit sous la référence 24.

De préférence, l'antenne 10 est imprimée sur circuit imprimé ou sur un élément diélectrique tel que la face interne du boitier principal de l'appareil 2.

Par exemple, l'antenne 10 et l'interface 8 sont adaptées pour communiquer selon un protocole de communication radio de type LoRa, ou Sigfox^{®}, ou LTE, ou Wifi, ou tout autre technologie équivalente.

La fréquence d'émission de l'antenne 10 est choisie en fonction du protocole de communication choisi. La fréquence de l'antenne dépend notamment de la forme et des dimensions de l'élément rayonnant 24. Dans le cas présent, à titre d'exemple illustratif, la fréquence est choisie égale à 2,4 GHz. D'autres fréquences sont toutefois possibles.

Le module amovible de communication radio comporte un élément de couplage 14, aussi nommé module de couplage 14, et une antenne radio extérieure 16 raccordée électriquement à l'élément de couplage 14.

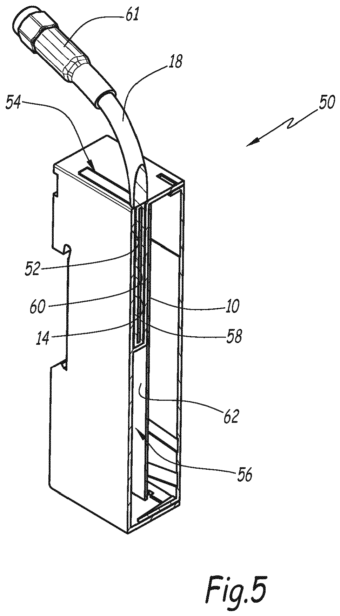

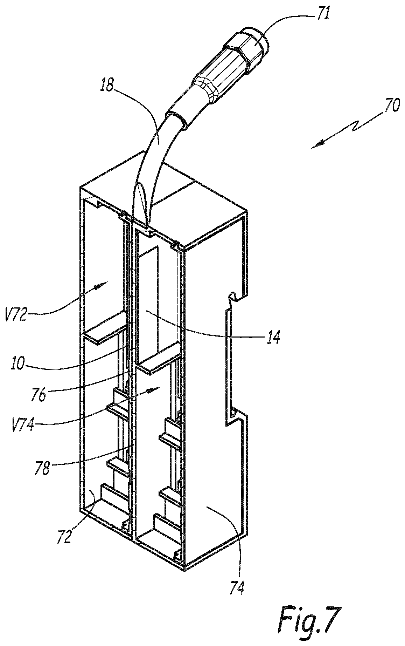

L'antenne 16 est ici raccordée à l'élément 14 par l'intermédiaire d'une liaison câblée 18, telle qu'un câble coaxial. Selon des modes de réalisation optionnels, l'antenne 16 est amovible. Par exemple, l'antenne 16 est connectée à la liaison 18 par l'intermédiaire d'un connecteur, qui porte la référence 61 et 71 sur les figures 5 et 7, respectivement.

De préférence, l'antenne 16 est placée à l'extérieur de l'armoire électrique 1. Ainsi, lorsque les parois de l'armoire électrique 1 sont réalisées en matière métallique, l'antenne extérieure 16 permet de maintenir une communication radio entre l'appareil 2 et un émetteur et/ou un récepteur distant, même lorsque l'appareil 2 est installé à l'intérieur de l'armoire électrique 1.

Plus précisément, le module 14 comporte au moins un élément rayonnant analogue à celui de l'antenne 10 et qui est décrit plus en détail dans ce qui suit sous la référence 34. L'antenne 16 est raccordée à l'élément rayonnant du module 14. La forme et fréquence du ou des éléments rayonnants du module 14 sont choisies de manière à être compatibles avec l'antenne 10. De préférence, la fréquence est la même que celle de l'antenne 10.

Dans cet exemple, l'antenne 10 comporte un seul élément rayonnant et le module 14 comporte également un seul élément rayonnant. Toutefois, en variante, le nombre d'élément(s) rayonnant(s) de l'antenne 10 et/ou du module 14 peuvent être différents. Ce qui est décrit en référence au présent exemple est néanmoins applicable

L'élément 14 est réversiblement déplaçable entre une position connectée avec le boîtier principal de l'appareil 2 et une position déconnectée du boîtier.

Dans la position connectée, l'antenne interne 10 est couplée avec le module 14, c'est-à-dire qu'au moins une partie de l'énergie rayonnée par l'antenne 10 lorsqu'elle est activée par l'interface 8 est reçue par le module 14 puis transmise vers l'antenne extérieure 16. Par exemple, au moins 50% ou 60% de l'énergie rayonnée par l'antenne 10 est reçue par le module 14. Par exemple, au moins 50%, ou au moins 60%, et de préférence au moins 70%, et de préférence encore au moins 75%, de l'énergie rayonnée sous forme d'ondes radio par l'élément rayonnant de l'antenne 10 est reçue par l'élément rayonnant correspondant du module 14.

Il en va de même lorsque l'antenne 10 reçoit un rayonnement émis par le module 14, par exemple lorsqu'un signal radio est reçu par l'antenne 16.

De plus, dans la position connectée, l'antenne interne 10 est disposé en face ou au voisinage du module 14 tout en étant séparée physiquement du module 14 par un élément électriquement isolant 12.

A titre d'exemple, dans la position connectée, l'élément 14 est placé en regard de l'antenne interne 10. Par exemple l'élément 14 et l'antenne 10 sont disposés face à face et sont séparés par une distance inférieure ou égale à 3cm ou, de préférence, inférieure ou égale à 1cm.

L'élément 12 autorise un couplage radio entre l'antenne 10 et le module 14 tout en empêchant un contact direct entre l'antenne 10 et le module 14. En particulier, l'élément 12 forme une barrière physique, tel qu'un écran rigide, qui est de préférence dépourvue d'ouverture ou de connecteur électrique. On comprend donc que l'antenne 10 et le module 14 ne peuvent alors pas communiquer par une liaison filaire et échangent ici des signaux uniquement sous forme d'ondes radio.

En d'autres termes, la connexion entre l'antenne 10 et le module 14 (et donc entre l'interface 8 et l'antenne extérieure 16) est réalisée sans fil, c'est-à-dire que cette connexion ne nécessite pas de continuité électrique filaire entre l'interface 8 et l'antenne externe 16. En particulier, cette connexion ne requiert pas la présence d'un connecteur physique au niveau d'une sortie de l'interface 8.

L'élément de couplage 14 transforme ensuite le rayonnement reçu en un signal électrique qui est transmis vers l'antenne extérieure 16, qui réémet à son tour un signal radio correspondant à destination d'un récepteur distant. Comme l'antenne 16 est située à l'extérieur de l'armoire électrique 1 accueillant l'appareil 2, le signal radio réémis par l'antenne 16 n'est pas gêné par les parois de l'armoire électrique. L'appareil électrique 2 peut donc être installé dans les armoires électriques même lorsque celles-ci sont réalisées en métal ou, de façon plus générale, sont susceptibles de perturber la transmission d'ondes électromagnétiques.

Dans la position montée, l'élément 14 se trouve à l'extérieur du boîtier principal de l'appareil 2. Il n'est pas en contact physique direct avec des éléments de l'appareil 2 qui seraient électriquement alimentés sous tension. De fait, l'élément 14 est électriquement isolé par rapport au courant électrique qui circule au niveau du dispositif 4 et/ou du courant électrique qui est susceptible d'alimenter électriquement l'interface 8 pour assurer son fonctionnement. De cette manière, une connexion est établie entre l'interface 8 et l'antenne 16 sans risquer de nuire à la sécurité des utilisateurs, et sans qu'il ne soit nécessaire d'utiliser une isolation galvanique au sein de l'appareil 2 pour protéger un circuit d'alimentation électrique de l'interface 8.

De plus, lorsque l'antenne 10 est couplée avec le module 14, elle génère moins de rayonnement radio vers d'autres régions de l'espace, notamment vers l'intérieur de l'armoire électrique 1, puisque la majorité de l'énergie rayonnée est transmise vers l'élément 14. En réduisant ce rayonnement non utile dans l'armoire électrique 1, on réduit les problèmes de compatibilité électromagnétique susceptibles d'intervenir dans l'armoire électrique 1.

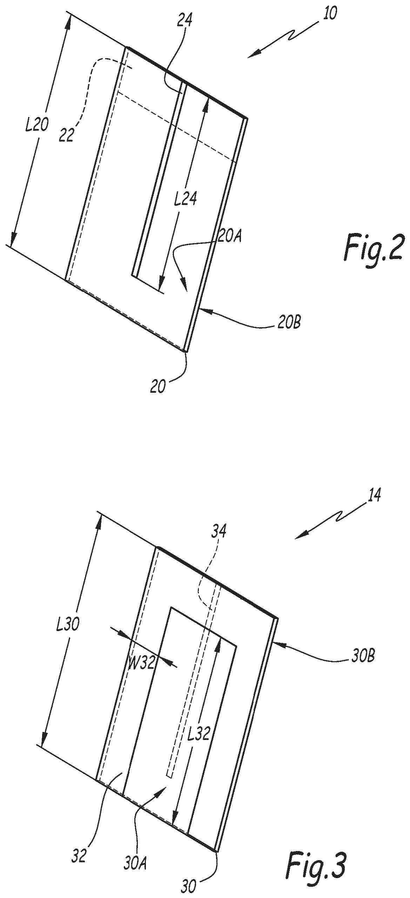

La figure 2 représente un exemple de l'antenne 10.

De préférence, l'antenne 10 est une antenne dipolaire. Plus particulièrement, il s'agit d'une antenne monopolaire, par exemple une antenne quart d'onde.

De façon générale, l'antenne 10 comporte de préférence un substrat diélectrique 20, un plan de masse 22 et au moins un élément rayonnant 24. L'antenne 10 forme ainsi une antenne planaire micro ruban, aussi nommée « microstrip antenna » en langue anglaise.

Dans ce mode de réalisation, le substrat diélectrique 20 est une plaque plane avec une forme de quadrilatère, par exemple un rectangle ou un carré. On note « L20 » la longueur du substrat 20, mesurée selon son plus grand côté. Dans cet exemple, la longueur L20 est inférieure ou égale à 50cm, par exemple égale à 40 mm. Le substrat 20 est une plaque de résine époxy de type FR4. Son épaisseur est ici inférieure ou égale à 1mm ou à 0,8mm.

En variante, d'autres types d'antenne planaire peuvent être utilisés pour réaliser l'antenne 10. Selon un exemple, on peut utiliser une antenne de type « slot antenna ». Selon d'autres exemples, l'antenne 10 est ménagée au sein d'une paroi du boîtier principal de l'appareil 2, par exemple en formant l'élément rayonnant 24 sur une face interne du boîtier principal de l'appareil 2, cette face tenant alors lieu de substrat diélectrique.

Sur la figure 2, les références « 20A » et « 20B » représentent des faces opposées du substrat 20. De préférence, l'élément rayonnant 24 et le plan de masse 22 sont réalisés sur des faces opposées du substrat 20. Dans cet exemple, l'élément rayonnant 24 est formé sur la face 20A et le plan de masse 22 est formé sur la face 20B.

L'élément rayonnant 24 comporte par exemple une piste métallique déposée sur le substrat 20. Par exemple, l'élément rayonnant 24 présente une forme rectiligne. Dans le cas où l'antenne 10 est une antenne mono-polaire, une première extrémité de l'élément rayonnant 24 est connectée à une sortie de l'interface 8. L'extrémité opposée forme un point chaud de l'antenne 10. La référence « L24 » désigne ici la longueur de l'élément rayonnant 24. Par exemple, la longueur L24 est égale à 32 mm.

Le plan de masse 22 est formée par une piste électriquement conductrice, par exemple métallique déposée sur la face 20B du substrat 20. Dans cet exemple, le plan de masse présente une forme de rectangle ménagée à la base de l'antenne 10. Le plan de masse 22 est connecté à une entrée de masse de l'interface 8. Par exemple, un connecteur coaxial, tel qu'un connecteur UFL ou MMCX, non illustré, est attaché à la base de l'antenne 10 de manière à permettre la connexion de l'élément rayonnant 24 et du plan de masse 22 avec l'interface 8.

En variante, ce connecteur coaxial peut être omis, notamment si l'antenne 10 est intégrée à l'interface 8, par exemple en étant formée sur un substrat diélectrique commun avec l'interface 8.

En variante, d'autres structures d'antenne 10 peuvent être utilisées.

Selon des modes de mise en oeuvre avantageux mais non indispensables, l'unité de commande 6 comporte un circuit imprimé incluant un substrat diélectrique sur lequel sont montés tout ou partie des composants de l'unité 6. Ce circuit imprimé porte la référence 62 dans l'exemple de la figure 5. Dans ce cas, l'antenne 10 est avantageusement formée sur ce circuit imprimé, c'est-à-dire que le substrat 20 correspond au substrat diélectrique du circuit imprimé de l'unité 6. En d'autres termes, le substrat 62 est commun à l'antenne 10 et à l'unité 6, voire aussi à l'interface 8.

La figure 3 représente un exemple du module de couplage 14.

Le ruban 34 est adapté pour recevoir un rayonnement électromagnétique émis par le ruban 24 de l'antenne 10, lorsque l'élément de couplage 14 est dans la position connectée et se trouve en regard de l'antenne 10.

De façon analogue au fonctionnement de l'antenne 10, l'élément rayonnant 34 est adapté pour émettre un rayonnement électromagnétique correspondant à un signal reçu par l'antenne extérieure 16, ce rayonnement étant ensuite reçu par l'antenne 10.

Dans cet exemple, l'élément de couplage 14 comporte un substrat diélectrique 30, et un plan de masse 32. L'élément rayonnant 34 et le plan de masse 32 sont ménagés sur des faces opposées 30A, 30B du substrat 30. Par exemple, le substrat 30 présente une forme de plaque plane. Le substrat 30 est préférentiellement réalisé dans le même matériau que le substrat 20.

Plus précisément, dans cet exemple, le plan de masse 32 est formé sur la face 30A. L'élément rayonnant est formé sur la face opposée 30B.

L'élément rayonnant est ici de forme rectiligne. Une première extrémité, par exemple celle se trouvant à une base du substrat 30, est connectée avec l'antenne extérieure 16.

A titre d'exemple, dans la position connectée, les substrats respectifs 20 et 30 de l'antenne 10 et du module 14 sont disposés face à face et de façon parallèle entre eux. De préférence, l'élément rayonnant 24 est aligné avec l'élément rayonnant 34.

La longueur de l'élément rayonnant 34 est de préférence égale à la longueur L24 du ruban 24. Par exemple, l'élément rayonnant 34 est une piste métallique déposée sur le substrat 30.

Selon des modes de mise en œuvre préférentiels mais non obligatoires, le plan de masse 34 présente une forme de C. Plus précisément, le plan de masse 32 comporte trois portions en forme de bandes connectées entre elles et s'étendant d'un seul tenant, chacune de ces portions s'étendant le long d'un des bords du substrat 30.

Par exemple, les largeurs de ces bandes, indiquées par la référence W32, sont identiques. La largeur W32, donnée uniquement à titre illustratif et non limitatif, est égale à 7 mm. On note « L32 » la longueur des bandes latérales mesurées par rapport au bord de la bande de base. La longueur L32, là aussi donnée uniquement à titre illustratif et non limitatif, est ici égale à 27 mm.

La forme en C du plan de masse permet de favoriser le couplage radio entre l'antenne 10 et l'élément 14. En effet l'élément 14 est dans la position connectée, les lignes de champ électrique sont confinés et guidés vers l'élément 14. On contribue encore plus à éviter que l'antenne rayonne des ondes électromagnétiques dans toutes les directions lorsque l'élément 14 est dans sa position connectée. En d'autres termes, le signal radio émis par l'antenne 7 est essentiellement dirigé vers l'élément de couplage 14. Cela améliore la qualité du couplage entre l'antenne 10 et l'élément 14 et réduit encore plus les problèmes de compatibilité électromagnétique.

D'autres formes que celle « en C » sont toutefois possibles.

Selon des modes de mise en œuvre préférentiels, l'élément isolant 12 est au moins en partie formé par une paroi du boîtier principal de l'appareil 2. Par exemple, l'antenne interne 10 est disposée à l'intérieur du boîtier principal en étant plaquée contre une face interne d'une paroi extérieure de ce boîtier principal. Le module 14 est adapté pour, dans la position connectée, être reçu contre la face opposée cette paroi.

A titre d'exemple, l'élément isolant 12 présente une épaisseur de 2 mm. Le matériau formant cette paroi 12 a une perméabilité électrique effective égale à 2,4. Par exemple, l'élément 12 est une matière plastique, telle que du polyamide PA66.

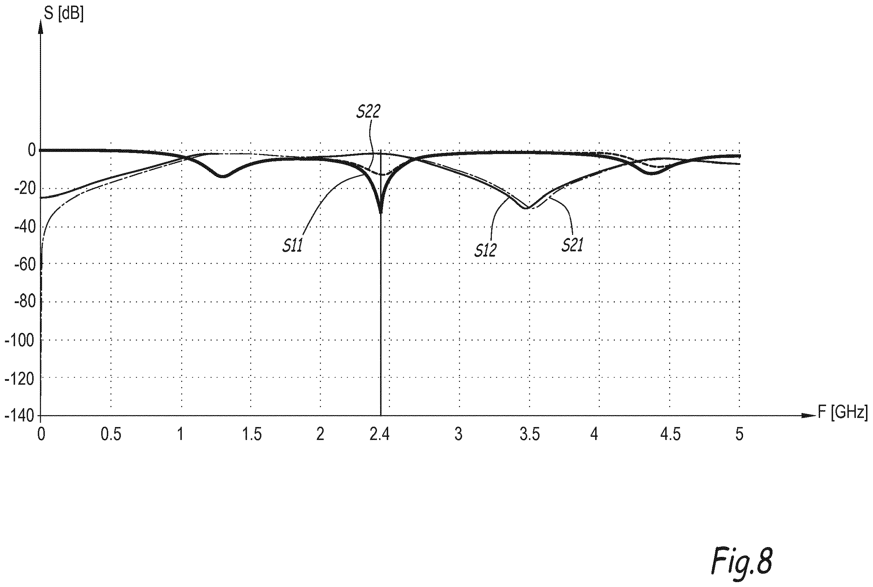

La figure 8 illustre, à titre d'exemple, l'évolution de valeurs d'amplitude des coefficients de transmission et de réflexion du système formé par l'association de l'antenne 10 avec l'élément 14 précédemment décrits à titre d'exemple, en fonction de la fréquence F d'un signal radio exprimée en Gigahertz. De tels coefficients sont connus sous le nom de « paramètres S » et sont notés S11, S21, S12 et S22. Leur définition est connue et n'est pas décrite en détail. Dans cet exemple, S11 est le coefficient de réflexion de l'antenne 10, S22 est le coefficient de réflexion du module 14, S21 est le coefficient de transmission de l'antenne 10 vers le module 14 et S12 est le coefficient de transmission du module 14 vers l'antenne 10.

Dans cet exemple, pour la fréquence de 2,4 GHz, l'antenne 10 et le module 14 présentent un coefficient de réflexion inférieur à -12dB. Le coefficient de transmission égal à -1,4dB. En d'autres termes, environ 72% de l'énergie émise par l'antenne 10 est collectée par l'élément 14. Dans cette configuration, le gain de l'antenne est de -3,86dBi, avec une efficacité totale de 6,8%.

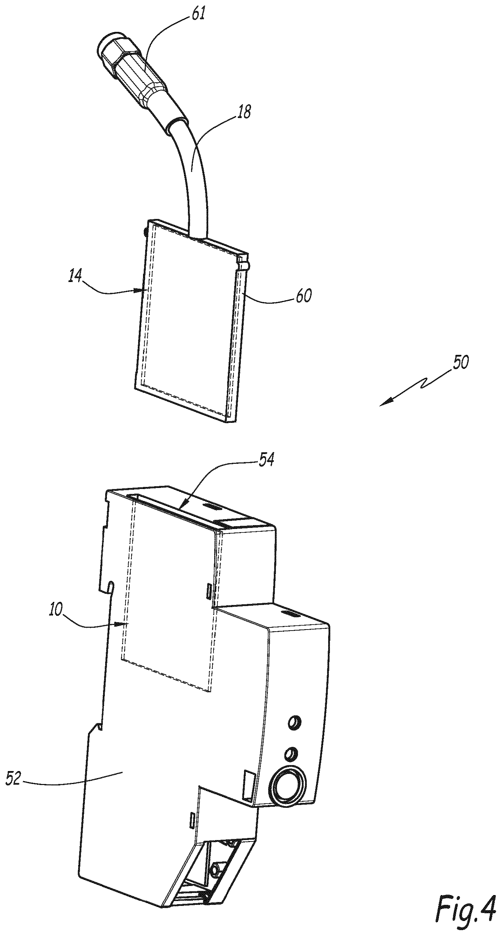

Les figures 4 à 7 représentent des variantes de construction de l'appareil 2.

Plus précisément, les figures 4 et 5 illustrent un appareil électrique 50 selon un premier mode de réalisation de l'appareil 2. Tout ce qui a été précédemment décrit en référence au fonctionnement de l'appareil 2, et notamment en référence à l'antenne 10 et à l'élément 14 s'applique à ce premier mode de réalisation.

La référence 52 désigne ici le boîtier principal de l'appareil 2. Ce boîtier 52 délimite à la fois un volume principal 56 et un logement 54 auxiliaire qui sont séparés l'un de l'autre par une paroi interne 58. Le logement 54 est accessible depuis l'extérieur du boîtier 52 par une fente. Le logement 54 est destiné à recevoir l'élément 14 lorsque celui-ci est dans sa position connectée. L'antenne interne 10 est logée à l'intérieur du volume 56 et n'est pas accessible physiquement depuis le logement 54. Ainsi, dans ce premier mode de réalisation, l'élément isolant 12 est formé par une partie de la paroi interne 58.

Le module 14 est ici logé dans un boîtier 60 de protection indépendant du boîtier principal 52. Dans la position connectée du module 14, le boîtier 60 est reçu à l'intérieur du logement 54 mais reste l'extérieur du volume 56. Dans la position déconnectée du module 14, le boîtier 60 est situé en dehors du logement 54. On comprend donc que le logement 54 présente une forme complémentaire à celle du boîtier 60 et que le boîtier 60 est adapté pour passer au travers de la fente. Le déplacement entre ces deux positions s'effectue ici par translation du boîtier 60. L'élément 14 est illustré dans sa position déconnectée sur la figure 4 et dans sa position connectée sur la figure 5.

Sur les figures 4 et 5, l'antenne extérieure 16 n'est pas illustrée. La référence 61 désigne un connecteur disposé sur une extrémité distale de la liaison câblée 18.

Le logement 54 est préférentiellement disposé en face de l'emplacement de l'antenne 10. En d'autres termes, l'antenne 10 est disposée contre une face de la paroi 58 et le logement 54 est formé du côté opposé de cette paroi 58.

L'appareil 50 permet ainsi de recevoir le module 14 sans trop augmenter l'encombrement du boîtier 52. Cela est particulièrement utile lorsque l'appareil 50 doit être utilisé au sein d'armoires électriques dans laquelle la place est limitée.

Selon des modes de mise en œuvre préférentiels, le boîtier 60 comporte des éléments de détrompage aptes à coopérer avec des éléments de forme complémentaire ménagés à l'intérieur du logement 54. Cela permet d'imposer un sens d'insertion prédéfini du boîtier 60 par rapport au boîtier 52 lors de son l'insertion dans le logement 54, par exemple pour que dans la position connectée, l'élément 14 soit aligné avec l'antenne 10 et/ou le plus près possible de la paroi 58.

Par exemple, le boîtier 60 comporte une ou plusieurs excroissances, visibles sur la figure 4, qui sont disposées en saillie par rapport au bord du boîtier 60. Le logement 54 comporte, sur des parois internes du boîtier, une ou plusieurs éléments de guidage, tels que des gorges ou des rainures, non illustrées, pour recevoir et guider les excroissances lors de l'insertion du boîtier 60 dans le logement 54. En variante, ce sont la ou les excroissances qui sont disposées à l'intérieur du logement 54 et ce sont la ou les gorges de forme complémentaire qui sont ménagées sur le boîtier 60.

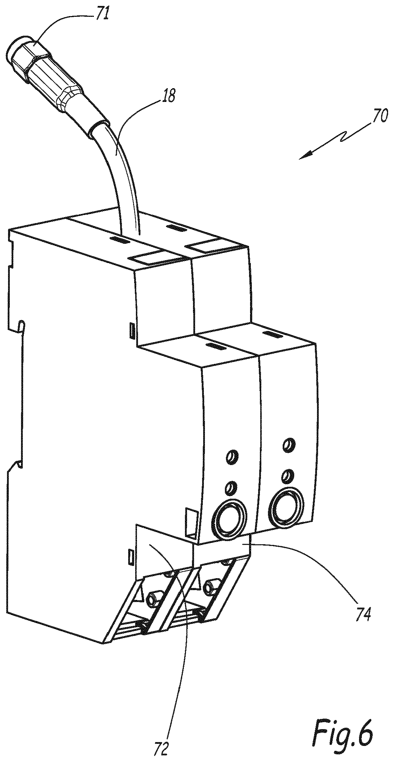

Les figures 6 et 7 illustrent un appareil électrique 70 selon un deuxième mode de réalisation de l'appareil 2. Les éléments de l'appareil électrique 70 selon ce deuxième mode de réalisation qui sont analogues à ceux du premier mode de réalisation portent les mêmes références et ne sont pas décrits en détail, dans la mesure où la description ci-dessus peut leur être transposée. En outre, la description précédemment faite de l'appareil 2, et notamment en référence à l'antenne 10 et à l'élément 14 s'applique à ce deuxième mode de réalisation.

Dans cet exemple, l'appareil 70 comporte deux boîtiers 72 et 74 qui présentent de préférence une forme similaire, voire identique. Les références V72 et V74 désignent, respectivement, les volumes internes des boîtiers 72 et 74. Le boîtier 72 joue le rôle de boîtier principal de l'appareil 70. L'antenne 10 est donc logée à l'intérieur du boîtier 72. L'élément 14 est quant à lui logé à l'intérieur du boîtier 74.

Dans la position connectée, le boîtier 74 est placé à côté du boîtier 72, au contact de celui-ci, en étant aligné avec celui-ci. Par exemple, les boîtiers 72 et 74 sont accrochés sur un même rail de fixation au sein de l'armoire électrique 1. De préférence, chacun de ces boîtiers 72 et 74 est pourvu d'organes de fixation permettant leur accrochage sur un même rail de fixation.

A l'intérieur du boîtier 72, l'antenne interne 10 est placée au contact d'une face interne d'une paroi 76 extérieure du boîtier 72. De façon analogue, à l'intérieur du deuxième boîtier 74, l'élément 14 est placé contre une face intérieure d'une paroi 78 extérieure du boîtier 74. Dans la position connectée, les parois 76 et 78 sont en contact l'une avec l'autre et se font face l'une avec l'autre. De cette façon, l'élément 14 se trouve en regard de l'antenne 10, aligné avec celle-ci, tout en étant séparé de celle-ci par les parois 76 et 78. Ainsi, dans ce deuxième mode de réalisation, l'élément isolant 12 et formé par les parois 76 et 78.

Ce deuxième mode de réalisation peut ainsi être mis en œuvre sans avoir besoin de modifier l'architecture du boîtier 72. En d'autres termes, il suffit de prendre un boîtier 74 existant, par exemple identique à celui du boîtier 72, et de l'équiper d'un élément 14 et la liaison câblée 18.

## Revendications

1. Appareil électrique (2; 50; 70) destiné à être installé dans une armoire électrique, cet appareil électrique comportant
- un dispositif (4) de gestion d'un courant électrique ;
- une unité de commande (6) électronique comportant une interface de communication (8) pourvue d'une antenne (10) interne logée à l'intérieur d'un premier boîtier (52, 72) de l'appareil électrique ;
l'antenne interne (10) étant une antenne planaire comportant un premier élément rayonnant (24),
l'appareil électrique (2 ; 50 ; 70) comportant en outre un élément de couplage (14) amovible connectable à une antenne radio extérieure (16), l'élément de couplage (14) étant pourvu d'un deuxième élément rayonnant (34) raccordable à l'antenne radio extérieure (16) et étant déplaçable entre une position connectée avec le premier boîtier de l'appareil électrique et une position déconnectée du premier boîtier, et,
dans la position connectée, l'élément de couplage (14) est disposé en face de l'antenne interne (10) en étant séparé de celle-ci par un élément électriquement isolant (12), le deuxième élément rayonnant (34) étant couplé avec le premier élément rayonnant (24) de sorte à recevoir un rayonnement électromagnétique émis par le premier élément rayonnant ;
l'appareil électrique (2 ; 50 ; 70) étant **caractérisé en ce que** l'interface de communication (8) est une interface de communication radio et **en ce que** l'antenne interne (10) est une antenne radio qui comporte un substrat diélectrique (20) et un plan de masse (22), le premier élément rayonnant (24) et le plan de masse étant formés sur des faces opposées du substrat diélectrique (20),
et **en ce que** l'élément de couplage (14) comporte un deuxième substrat diélectrique (30) et un deuxième plan de masse (32), le deuxième élément rayonnant (34) et le deuxième plan de masse (32) étant formés sur des faces opposées du deuxième substrat diélectrique (30).

2. Appareil électrique selon la revendication 1, **caractérisé en ce que** le plan de masse (32) de l'élément de couplage (14) comporte une couche métallique qui présente une forme en C.

3. Appareil électrique (50) selon l'une quelconque des revendications précédentes, **caractérisé en ce que** le premier boîtier (52) de l'appareil comporte un logement interne (54) destiné à recevoir l'élément de couplage (14) lorsqu'il est dans la position connectée et un volume intérieur (56) à l'intérieur duquel l'antenne interne (10) est logée, le logement interne (54) étant disposé en regard de l'antenne interne (10) et en étant séparé de l'antenne interne (10) par une paroi dudit premier boîtier (58).

4. Appareil électrique (50) selon la revendication 3, **caractérisé en ce que** l'élément de couplage (14) comporte un boîtier de protection (60) indépendant du premier boîtier (52) de l'appareil (50), le boîtier de protection (60) comportant au moins un élément de détrompage destiné à coopérer avec un élément de guidage de forme complémentaire ménagé à l'intérieur du logement (54).

5. Appareil électrique (70) selon l'une des revendications 1 à 2, **caractérisé en ce que** l'élément de couplage (14) est logé dans un deuxième boîtier (74) distinct du premier boîtier (72) de l'appareil (70), le deuxième boîtier (74) présentant une forme analogue ou identique à celle du premier boîtier (72) de l'appareil (70) et **en ce que** dans la position connectée, ledit deuxième boîtier est disposé à l'extérieur du premier boîtier (72) de l'appareil.

6. Appareil électrique selon l'une quelconque des revendications précédentes, **caractérisé en ce que** l'élément isolant (12) est au moins en partie formé par une paroi (58, 76, 78) du premier ou du deuxième boîtier de l'appareil (2).

7. Appareil électrique selon l'une quelconque des revendications précédentes, **caractérisé en ce que** l'antenne interne (10) est une antenne monopolaire, telle qu'une antenne quart d'onde.

8. Appareil électrique selon l'une quelconque des revendications précédentes, **caractérisé en ce que** l'unité de commande (6) comporte un circuit imprimé (62) et **en ce que** l'antenne interne (10) est formée sur ce circuit imprimé.

9. Appareil électrique selon l'une quelconque des revendications précédentes, **caractérisé en ce que**, dans la position connectée, le module (14) de couplage collecte au moins 60% de l'énergie rayonnée par l'antenne (10).

10. Armoire électrique (1) comportant un appareil électrique (2 ; 50 ; 70) placé à l'intérieur de l'armoire électrique et raccordé à une installation électrique, **caractérisée en ce que** l'appareil électrique (2 ; 50 ; 70) est selon l'une quelconque des revendications précédentes, une antenne extérieure (16) connectée à l'élément de couplage (14) de l'appareil électrique étant placée à l'extérieur de l'armoire électrique.

## Patentansprüche

1. Elektrisches Gerät (2; 50; 70), das zum Einbau in einen Schaltschrank bestimmt ist, dieses elektrische Gerät umfassend
- eine Vorrichtung (4) zur Verwaltung eines elektrischen Stroms;
- eine elektronische Steuereinheit (6), umfassend eine Kommunikationsschnittstelle (8), die mit einer internen Antenne (10) versehen ist, die im Innern eines ersten Gehäuses (52, 72) des elektrischen Geräts untergebracht ist;
wobei die interne Antenne (10) eine Planarantenne ist, umfassend ein erstes strahlendes Element (24),
das elektrische Gerät (2; 50; 70) ferner umfassend ein abnehmbares Kopplungselement (14) umfasst, das mit einer externen Funkantenne (16) verbunden werden kann, wobei das Kopplungselement (14) mit einem zweiten strahlenden Element (34) versehen ist, das mit der externen Funkantenne (16) verbunden werden kann und zwischen einer Position, die mit dem ersten Gehäuse des elektrischen Geräts verbunden ist, und einer Position, die von dem ersten Gehäuse getrennt ist, verschiebbar ist, und das Kopplungselement (14) in der verbundenen Position gegenüber der interne Antenne (10) angeordnet ist, indem es von dieser durch ein elektrisch isolierendes Element (12) getrennt ist, wobei das zweite strahlende Element (34) mit dem ersten strahlenden Element (24) gekoppelt ist, um elektromagnetische Strahlung zu empfangen, die von dem ersten strahlenden Element ausgesendet wird;
wobei das elektrische Gerät (2; 50; 70) **dadurch gekennzeichnet ist, dass** die Kommunikationsschnittstelle (8) eine Funkkommunikationsschnittstelle ist und dass die interne Antenne (10) eine Funkantenne ist, die ein dielektrisches Substrat (20) und eine Masseebene (22) umfasst, wobei das erste strahlende Element (24) und die Masseebene auf gegenüberliegenden Seiten des dielektrischen Substrats (20) gebildet sind,
und dass das Kopplungselement (14) ein zweites dielektrisches Substrat (30) und eine zweite Masseebene (32) umfasst, wobei das zweite strahlende Element (34) und die zweite Masseebene (32) auf gegenüberliegenden Seiten des zweiten dielektrischen Substrats (30) gebildet sind.

2. Elektrisches Gerät nach Anspruch 1, **dadurch gekennzeichnet, dass** die Masseebene (32) des Kopplungselements (14) eine Metallschicht umfasst, die C-förmig ist.

3. Elektrisches Gerät (50) nach einem der vorherigen Ansprüche, **dadurch gekennzeichnet, dass** das erste Gehäuse (52) des Geräts eine innere Aufnahme (54), die dazu bestimmt ist, das Kopplungselement (14) aufzunehmen, wenn es in der verbundenen Position ist, und ein inneres Volumen (56), in dessen Innerem die interne Antenne (10) untergebracht ist, umfasst, wobei die innere Aufnahme (54) gegenüber der internen Antenne (10) angeordnet ist und von der internen Antenne (10) durch eine Wand des ersten Gehäuses (58) getrennt ist.

4. Elektrisches Gerät (50) nach Anspruch 3, **dadurch gekennzeichnet, dass** das Kopplungselement (14) ein Schutzgehäuse (60) umfasst, das von dem ersten Gehäuse (52) des Geräts (50) unabhängig ist, das Schutzgehäuse (60) umfassend mindestens ein Codierungselement, das dazu bestimmt ist, mit einem Führungselement mit komplementärer Form zusammenzuwirken, das im Inneren der Aufnahme (54) gebildet ist.

5. Elektrisches Gerät (70) nach einem der Ansprüche 1 bis 2, **dadurch gekennzeichnet, dass** das Kopplungselement (14) in einem zweiten Gehäuse (74) untergebracht ist, das von dem ersten Gehäuse (72) des Geräts (70) getrennt ist, wobei das zweite Gehäuse (74) eine ähnliche oder identische Form wie das erste Gehäuse (72) des Geräts (70) aufweist, und dass in der verbundenen Position das zweite Gehäuse außerhalb des ersten Gehäuses (72) des Geräts angeordnet ist.

6. Elektrisches Gerät nach einem der vorherigen Ansprüche, **dadurch gekennzeichnet, dass** das isolierende Element (12) zumindest teilweise durch eine Wand (58, 76, 78) des erste oder zweite Gehäuse des Geräts (2) gebildet ist.

7. Elektrisches Gerät nach einem der vorherigen Ansprüche, **dadurch gekennzeichnet, dass** die interne Antenne (10) eine monopolare Antenne, wie beispielsweise eine Viertelwellenantenne, ist.

8. Elektrisches Gerät nach einem der vorherigen Ansprüche, **dadurch gekennzeichnet, dass** die Steuereinheit (6) eine gedruckte Schaltung (62) umfasst und dass die interne Antenne (10) auf dieser gedruckten Schaltung gebildet ist.

9. Elektrisches Gerät nach einem der vorherigen Ansprüche, **dadurch gekennzeichnet, dass** das Kopplungsmodul (14) in der verbundenen Position mindestens 60 % der von der Antenne (10) abgestrahlten Energie sammelt.

10. Schaltschrank (1), umfassend ein elektrisches Gerät (2; 50; 70), das im Inneren des Schaltschranks angeordnet und mit einer elektrischen Anlage verbunden ist, **dadurch gekennzeichnet, dass** das elektrische Gerät (2; 50; 70) gemäß einem der vorherigen Ansprüche ist, wobei eine Außenantenne (16), die mit dem Kopplungselement (14) des elektrischen Geräts verbunden ist, außerhalb des Schaltschranks angeordnet ist.

## Claims

1. An electrical apparatus (2; 50; 70) for installation in an electrical cabinet, said electrical apparatus comprising
- a device (4) for managing an electric current;
- an electronic control unit (6) comprising a communication interface (8) provided with an internal antenna (10) housed inside a first housing (52, 72) of the electrical apparatus;
the internal antenna (10) being a planar antenna with a first radiating element (24),
the electrical apparatus (2; 50; 70) further comprising a removable coupling element (14) connectable to an external radio antenna (16), the coupling element (14) being provided with a second radiating element (34) connectable to the external radio antenna (16) and being movable between a position connected with the first housing of the electrical apparatus and a position disconnected from the first housing, and in the connected position, the coupling element (14) is disposed in front of the internal antenna (10) and separated therefrom by an electrically insulating element (12), the second radiating element (34) being coupled to the first radiating element (24) so as to receive electromagnetic radiation emitted by the first radiating element;
the electrical apparatus (2; 50; 70) being **characterised in that** the communication interface (8) is a radio communication interface and **in that** the internal antenna (10) is a radio antenna which comprises a dielectric substrate (20) and a ground plane (22), the first radiating element (24) and the ground plane being formed on opposite sides of the dielectric substrate (20),
and **in that** the coupling element (14) comprises a second dielectric substrate (30) and a second ground plane (32), the second radiating element (34) and the second ground plane (32) being formed on opposite sides of the second dielectric substrate (30).

2. The electrical apparatus according to claim 1, **characterised in that** the ground plane (32) of the coupling element (14) has a metal layer which is C-shaped.

3. The electrical apparatus (50) according to any of the preceding claims, **characterised in that** the first housing (52) of the apparatus comprises an internal recess (54) for receiving the coupling element (14) when in the connected position and an internal volume (56) within which the internal antenna (10) is accommodated, the internal recess (54) being disposed opposite the internal antenna (10) and being separated from the internal antenna (10) by a wall of said first housing (58).

4. The electrical apparatus (50) according to claim 3, **characterised in that** the coupling element (14) comprises a protective housing (60) independent of the first housing (52) of the apparatus (50), the protective housing (60) comprising at least one keying element intended to co-operate with a complementary-shaped guide element provided within the recess (54).

5. The electrical apparatus (70) according to any of claims 1 to 2, **characterised in that** the coupling element (14) is housed in a second housing (74) separate from the first housing (72) of the apparatus (70), the second housing (74) having a shape similar or identical to that of the first housing (72) of the apparatus (70), and **in that** in the connected position said second housing is disposed outside the first housing (72) of the apparatus.

6. The electrical apparatus according to any of the preceding claims, **characterised in that** the insulating element (12) is at least partly formed by a wall (58, 76, 78) of the first or second apparatus housing (2).

7. The electrical apparatus according to any of the preceding claims, **characterised in that** the internal antenna (10) is a monopole antenna, such as a quarter-wave antenna.

8. The electrical apparatus according to any of the preceding claims, **characterised in that** the control unit (6) comprises a printed circuit (62) and **in that** the internal antenna (10) is formed on this printed circuit.

9. The electrical apparatus according to any of the preceding claims, **characterised in that**, in the connected position, the coupling module (14) collects at least 60% of the energy radiated by the antenna (10).

10. An electrical cabinet (1) comprising an electrical apparatus (2; 50; 70) placed inside the electrical cabinet and connected to an electrical installation, **characterized in that** the electrical apparatus (2; 50; 70) is according to any of the preceding claims, an external antenna (16) connected to the coupling element (14) of the electrical apparatus being placed outside the electrical cabinet.
